# EUROPEAN PATENT SPECIFICATION

(11) **EP 4 528 809 B1**
(45) Date of publication and mention of the grant of the patent: **19.08.2026**
(21) Application number: 23199072.2
(22) Date of filing: 22.09.2023
(51) Int. Cl.: H10W 70/40, H10W 72/00, H10W 72/60

(54) **CLIP, SEMICONDUCTOR DEVICE AND MANUFACTURING METHOD OF SEMICONDUCTOR DEVICE**
CLIP, HALBLEITERBAUELEMENT UND VERFAHREN ZUR HERSTELLUNG EINES HALBLEITERBAUELEMENTS
CLIP, DISPOSITIF SEMI-CONDUCTEUR ET PROCEDE DE FABRICATION D'UN DISPOSITIF SEMI-CONDUCTEUR

(43) Date of publication of application: 26.03.2025
(73) Proprietor: Nexperia B.V., 6534 AB Nijmegen (NL)
(72) Inventor: Shiu, Heiming, 22529 Hamburg (DE); El-Zammar, Georgio, Hamburg (DE); Ramalingam, Vegneswary, 71450 Seremban (MY)
(74) Representative: Pjanovic, Ilija

(56) References cited:
- US-A1- 2018 158 757
- US-A1- 2020 105 707

## Description

### Field of Invention

The present invention relates to a clip for a semi-conductor device, to a semi-conductor device that comprises the clip, and to a method of manufacturing the semi-conductor device.

### Background

Semiconductor assemblies, such as transistors, are manufactured as layered assemblies including components such as die paddles, dies, clips and a casing. The casing provides a protective functionality and at least partially surrounds the die and other components that form a part of the semiconductor assembly.

Semiconductor assemblies are subject to temperature fluctuations in use. These temperature fluctuations result in the expansion and contraction of the components of the clip. The coefficient of thermal expansion of each component is different, and so the amount by which each component expands and contracts as a result of temperature changes is also different. This leads to internal stresses accumulating within the components of the clip. The internal stresses are undesirable because they can result in delamination of the components of the clip. Other causes of delamination of the components of the clip exist. A semiconductor assembly with such clips are dislosed, for example, in US 2018/158757 A1.

There exists a need to overcome the disadvantages associated with existing semiconductor assemblies, and clips for semi-conductor assemblies, whether mentioned in this document or otherwise.

### Summary

In a first aspect of the invention there is provided a clip for a semi-conductor device. At least part of the clip is formed from a metallic foam.

In use, semi-conductor devices are subject to temperature fluctuations, and may in some applications experience temperatures over a 200°C or greater range. Therefore, semi-conductors are typically designed to withstand temperatures as low as -65°C (or lower), and up to 150°C (or higher). These fluctuations lead to variations in the sizes of the components of the devices due to thermal expansion. The clip is generally made from a different material to the die to which it is secured, and to the solder used to secure the clip to the die. For example, the clip may be made from copper whereas the die may be made from silicone and the solder from a lead alloy. Each of these materials has a different coefficient of thermal expansion, and so each of the components expands and contracts with temperature changes at a different rate. This leads to internal stresses building up within the components, which can lead to delamination of the components and ultimately failure of the semi-conductor device. Conventional clips are typically made from solid copper, and so are rigid. This reduces the ability of the clip to absorb stress in use. Since at least part of the clip is formed from a metallic foam, the clip is able to better absorb the stresses that it is subject to in use. This reduces the likelihood of delamination of the components of a semi-conductor device that the clip forms a part of.

The semi-conductor device comprises an isolator that covers, and adheres to, the clip. The clip being formed of a foam improves adhesion between the clip and the isolator because the isolator enters the holes defined by the foam, which provides a greater contact area between the isolator and the clip. This advantageously reduces the likelihood of separation of the isolator from the clip.

The pore size of the foam is at least 10µm. The pore size of the foam is up to 100µm.

The pore size may be up to 50µm. The pore size may be at least 10µm and/or up to 30µm. The pore size may be 20µm.

The conductivity of the clip is inversely proportional to the pore size. The flexibility of the clip is proportional to the pore size. Where the pore size of the foam is at least 10µm and up to 100µm, the balance of the conductivity of the clip and the flexibility of the clip is advantageously optimised. This allows the clip to operate efficiently, while reducing the likelihood of delamination.

As an alternative or additionally to the pore size, the part or parts of the clip that is formed from a metallic foam has a porosity of at least 30% and/or up to 80%.

The conductivity of the clip is inversely proportional to porosity. The flexibility of the clip is proportional to porosity. Where the porosity of the clip is at least 30% and/or up to 80%, the balance of the conductivity of the clip and the flexibility of the clip is advantageously optimised. This allows the clip to operate efficiently, while reducing the likelihood of delamination.

The metallic foam may be formed of copper.

The metallic foam may be an open cell foam.

The foam may be a reticulated foam.

The term reticulated may be understood to mean that the material of the clip forms a network of interconnected branches. That is to say, one can move from one point of the clip to any other point whilst maintaining contact with the material of the clip.

Where the foam is an open cell foam, the clip is able to better absorb internal stresses that the clip may be subject to in use.

The entirety of the clip may be formed from a metallic foam.

In a second aspect of the invention there is provided a semi-conductor device. The semi-conductor device comprises a lead frame that comprises a die attach portion and a lead portion; a semi-conductor die mounted on the die attach portion; and a clip according to the first aspect of the invention. At least part of the clip is secured to the semi-conductor die. At least part of the clip is secured to the lead portion.

The advantages discussed above in relation to the first aspect of the invention apply to this aspect mutatis mutandis.

In a third aspect of the invention there is provided a method of manufacturing a semi-conductor device. The method comprises providing a lead frame. The lead frame comprises a die attach portion and a lead portion. The method further comprises: attaching a semi-conductor die to the die attach portion of the leadframe; providing a first metallic layer to the semi-conductor die and providing a second metallic layer to the lead portion; providing the clip of the first aspect of the invention such that a first portion of the clip contacts the first metallic layer and a second portion of the clip contacts the second metallic layer; and heating the clip, the first metallic layer, and the second metallic layer such that the first metallic layer and the second metallic layer melt.

The advantages discussed above in relation to the first aspect of the invention apply to this aspect mutatis mutandis.

The method may further comprise providing a cover. The cover may be provided such that it encapsulates the lead frame, preferably excluding at least part of any leads of the lead frame, the semi-conductor die, and the clip.

Melting of the first metallic layer and of the second metallic layer may cause the first metallic layer and the second metallic layer to migrate into the clip to form a first joint and a second joint respectively.

The first metallic layer and the second metallic layer may migrate into the clip by capillary action.

The first joint may comprise a portion that is disposed in the region of the first portion of the clip and a portion that is disposed in the region of the first metallic layer. The second joint may comprise a portion that is disposed in the region of the second portion of the clip and a portion that is disposed in the region of the second metallic layer.

The first joint and the second joint may be formed upon cooling of the assembly.

The melting temperature of the first joint and of the second joint may be at least 400°C.

Where the melting temperature of the first and second joints is at least 400°C, the likelihood of the first and second joint melting while the semi-conductor device is being secured to an external circuit is reduced. Melting of the first and/or second joint while the semi-conductor device is being secured to an external circuit is undesirable because it can lead to a reduction in the strength of the joint. Therefore, reducing the likelihood of melting of the first and second joints reduces the likelihood of short circuiting and current leakage in use. Therefore, where the melting temperature of the first and second joints is at least 400°C, the semi-conductor device resulting from the method is advantageously more reliable.

Prior to being heated, the first metallic layer and the second metallic layer may be formed from tin and the clip is formed from copper. The first joint and the second joint may be formed from a copper-tin intermetallic compound.

The first metallic layer and the second metallic layer may be formed from pure tin.

Where the metallic layers are formed from tin and the clip is formed from copper, the use of solder to secure the clip to the die and lead frame is not necessary. Furthermore, the likelihood of the first and/or second joint melting during assembly of the semi-conductor device into an external circuit is reduced as compared to if a conventional solder material were used to connect the clip to the lead frame and die. Melting of conventional solder material during assembly can increase the likelihood of short circuiting and/or current leakage in use Re-melting of conventional solder reduces the maximum peak forward surge current of semi-conductor devices. Therefore, by reducing the likelihood of the first and/or second joint melting during assembly of the semi-conductor device into an external circuit, the maximum peak forward surge current is improved. Therefore, where the metallic layers are formed from tin and the clip is formed from copper, the semi-conductor device resulting from the method is advantageously more reliable.

Neither the first metallic layer nor the second metallic layer may be formed from lead.

Lead waste can contaminate the environment. Where neither the first metallic layer nor the second metallic layer are formed from lead, the method is more environmentally friendly.

### Brief Description of the Drawings

Embodiments of the present invention will now be described with reference to the accompanying drawings, in which:
Figure 1 shows a perspective view of a semi-conductor device;
Figure 2 shows a perspective view of a semi-conductor device according to a second embodiment of the invention; and
Figures 3 to 5 show side views of assembly and manufacture steps for the semi-conductor device of Figure 1.

### Detailed Description

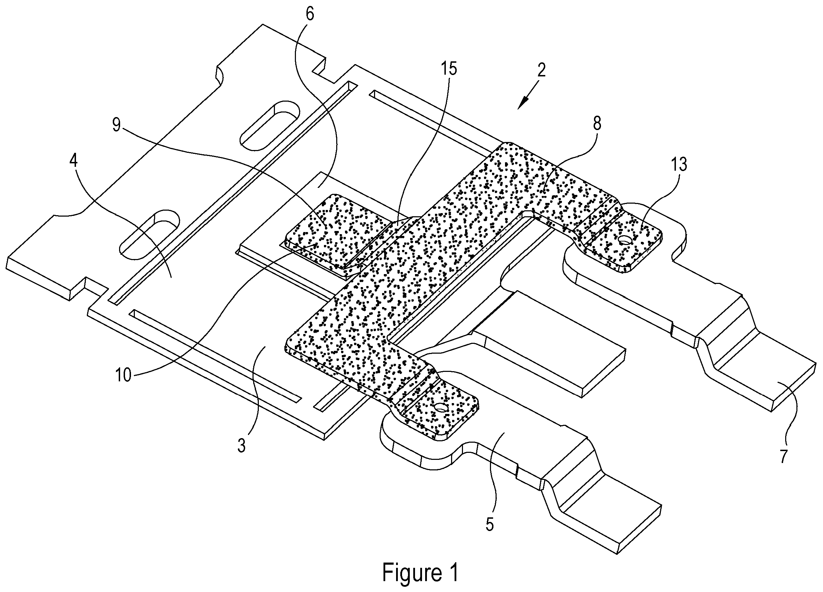

Figure 1 shows a semiconductor device 2. The semi-conductor device 2 comprises a lead frame 4. The lead frame 4 may also be referred to as a die paddle. The semi-conductor device 2 comprises a die 6. The semi-conductor device 2 comprises a clip 8. The semi-conductor device 2 comprises a cover (not shown in Figure 1 for clarity).

The lead frame 4 serves as a base of the semi-conductor device 2 to which other components of the device are attached. The lead frame 4 comprises a die attach portion 3. The die 6 is secured to the die attach portion 3. The lead frame 4 comprises a lead portion 5. The lead portion 5 comprises a plurality of leads 7 (only one of which is labelled in Figure 1). The plurality of leads allow the semiconductor device 2 to be connected to an external circuit (not shown). Each portion of the lead frame 4 is generally rectangular. However, in other embodiments, the portions of the lead frame may be any suitable shape. The lead frame 4 is manufactured from a conductive material such as copper (including a copper alloy). The lead portion 5 is separately formed from the die attach portion 3. However, in some embodiments, the lead portion 5 and the die attach portion may be integrally formed.

The die 6 is secured to the lead frame 4. The die 6 is secured to the lead frame 4 by virtue of a first solder layer 10. In particular, the die 6 is secured to the die attach portion 3 of the lead frame 4 by the first solder layer 10. The die 6 may be a single component or may comprise multiple constituent components. The die 6 is made of a semiconducting material. The die 6 has a functional circuit fabricated thereon. The die 6 is generally rectangular but may be any other suitable shape. The die 6 is plate like in shape.

The cover encapsulates the components of the semi-conductor device 2 (i.e., the lead frame 4, the die 6, and the clip 8). The leads 7 of the clip 8 extend through the cover. This allows the leads 7 to be connected to the external circuit (not shown). The cover may be made from any suitable electrically isolating material, such as an epoxy. The cover may also be referred to as an isolator, a casing, or an encapsulant.

The clip 8 comprises a first portion 9, a second portion 13, and an intermediate portion 15. The second portion 13 comprises a first arm and a second arm. However, in some embodiments, the second portion 13 may comprise only a single arm. The intermediate portion 15 adjoins and is disposed between the first portion 9 and the second portion 13.

The clip 8 is secured to the die 6. In particular, the first portion 9 of the clip 8 is secured to the die 6. The clip 8 is secured to the lead portion 5 of the lead frame 4. In particular, the second portion 13 of the clip 8 is secured to the lead portion 5 of the lead frame 4. The clip 8 thus electrically connects the die 6 and the lead portion 5 of the lead frame 4. The clip 8 may otherwise be referred to as a connector.

The clip 8 is formed from a metallic foam. The clip 8 may be formed from a copper foam. In some embodiments, the clip may be formed from a nickel or silver foam. Copper is, however, preferred due to its thermal and electrical conductivity, availability, and cost. The entirety of the clip 8 may be formed from a metallic foam. The foam may be either open cell or closed cell. The foam from which the clip 8 is formed has a pore size of at least 10µm and up to 100µm. In some embodiments, the pore size may be up to 50µm. In some embodiments, the pore size may be at least 10µm and/or up to 30µm. In some embodiments, the pore size may be 20µm. The pore size may be chosen based on the desired flexibility of the clip 8. As an alternative or additionally to the pore size, the porosity of the clip 8 is at least 30% and/or up to 80%. The porosity of the clip 8 may be chosen based on the desired flexibility of the clip 8. The clip 8 being formed from a foam increases the flexibility of the clip 8 as compared to if the clip 8 were formed from a continuous or solid material. This advantageously allows the clip 8 to absorb internal stresses that arise as a result of temperature fluctuations of the semi-conductor device 2 in use. The clip 8 being formed from a foam also better secures the cover to the clip 8. This is because cover at least partially enters the pores of the clip 8, which increases the contact area between the clip 8 and cover as compared to if the clip 8 were formed from a solid material. The clip 8 being able to better absorb internal stresses and the cover being better secured to the clip 8 advantageously reduce the likelihood of delamination of the components of the semi-conductor device 2 in use.

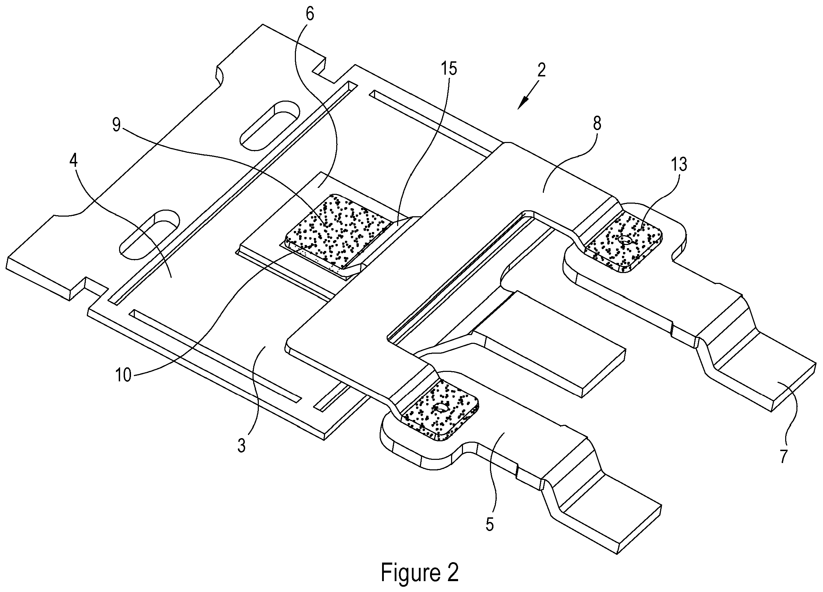

In the embodiment shown in Figure 2, only the first portion 9 and the second portion 13 are formed from a metallic foam. In particular, the first portion 9 and distal regions of the first and second arms of the second portion 13 may be formed from a metallic foam.

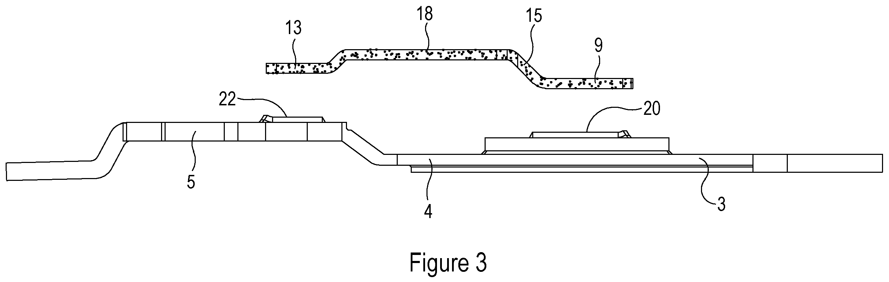

The process by which the clip 8 is secured to the lead frame 4 and die 6 will now be discussed with reference to Figures 3 to 5. The process applies to both the clip 8 shown in Figure 1 and the clip 8 shown in Figure 2. Referring first to Figure 3, a first metallic layer 20 is applied to the die 6. The first metallic layer 20 may be applied using electroplating or sputtering. These methods of application are advantageously more efficient that the conventional soldering method. This is because electroplating or sputtering of the first metallic layer 20 can take place during assembly of other components onto the die 6 using the same method. The first metallic layer 20 may be at least 2µm and/or up to 10µm thick. The thickness of the first metallic layer 20 may be chosen based on, for example, the desired contact area between the die 6 and the clip 8, the size of the clip 8 and of the semi-conductor device 2. A second metallic layer 22 is applied to the lead portion 5 of the lead frame 4. The second metallic layer 22 may be applied using electroplating. The second metallic layer 22 may be at least 2µm and/or up to 10µm thick. The thickness of the second metallic layer 22 may be chosen based on, for example, the size of the clip 2 and of the semi-conductor device 2. The first metallic layer 20 and the second metallic layer 22 may be formed from tin, preferably pure tin. In some embodiments, the first metallic layer 20 and/or the second metallic layer 22 may be formed from indium. The material of the first metallic layer 20 and the second metallic layer 22 may be chosen based on the material from which the clip 8 is made. In some embodiments, neither the first metallic layer 20 nor the second metallic layer 22 contain lead.

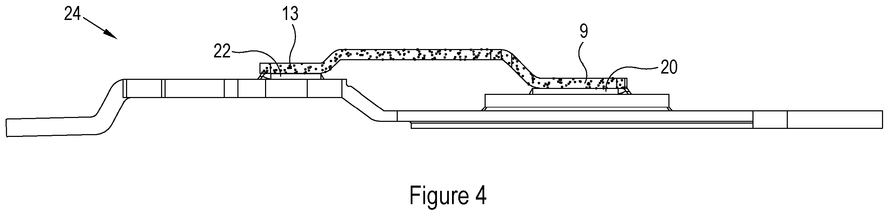

The clip 8 is then positioned such that the first portion 9 of the clip 8 contacts the first metallic layer 20 and the second portion 13 of the clip 8 contacts the second metallic layer 22. The resulting assembly 24 is shown in Figure 4. The assembly 24 is then heated. The temperature to which the assembly 24 is heated is determined by the material from which the first metallic layer 20 and the second metallic layer 22 are made. In particular, the assembly 24 is heated to at least the melting temperature of the first metallic layer 20 and of the second metallic layer 22. Where the first metallic layer 20 and the second metallic layer 22 are formed from tin, preferably pure tin, the temperature to which the assembly 24 is heated may be at least 232°C.

Melting of the first metallic layer 20 and of the second metallic layer 22 causes the first metallic layer 20 and the second metallic layer 22 to migrate into the clip 8. The first metallic layer 20 and of the second metallic layer 22 migrate into the clip 8 by capillary action. The first metallic layer 20 and the second metallic layer 22 migrate into the clip 8 in the region of the first portion 9 and the second portion 13 of the clip 8 respectively. However, it will be appreciated that some of the first metallic layer 20 and some of the second metallic layer 22 may migrate beyond the first portion 9 and beyond the second portion 13. Once the first metallic layer 20 and the second metallic layer 22 have melted, the assembly 24 is cooled.

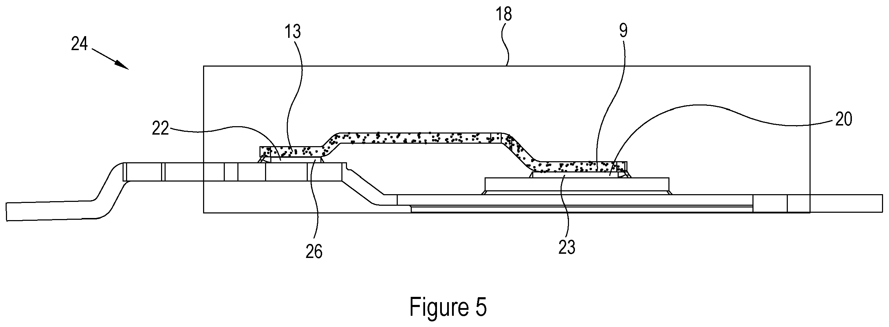

Figure 5 shows the assembly 24 following cooling. Melting and cooling of the first metallic layer 20 results in the formation of a first joint 23. A portion of the first joint 23 is disposed in the region of the first portion 9 of the clip 8, and a portion is disposed in the region of the first metallic layer 20. The first joint 23 secures the first portion 9 of the clip 8 to the die 6. The first joint 23 is formed of an intermetallic compound. The intermetallic compound of the first joint 23 comprises the material from which the clip 8 is made (prior to heating) and the material from which the first metallic layer 20 is made (prior to heating). The intermetallic compound of the first joint 23 is a copper-tin compound. In some embodiments, the intermetallic compound of the first joint 23 may be a nickel-tin compound, a silver-tin compound, or a copper-indium compound.

Melting and cooling of the second metallic layer 22 results in the formation of a second joint 26. A portion of the second joint 26 is disposed in the region of the second portion 13 of the clip 8, and a portion is disposed in the region of the second metallic layer 22. The second joint 26 secures the second portion 13 of the clip 8 to the lead portion 5 of the lead frame 4. The second joint 26 is formed of an intermetallic compound. The intermetallic compound of the second joint 26 comprises the material from which the clip 8 is made (prior to heating) and the material from which the second metallic layer 22 is made (prior to heating). The intermetallic compound of the second joint 26 is a copper-tin compound. In some embodiments, the intermetallic compound of the second joint 26 may be a nickel-tin compound, a silver-tin compound, or a copper-indium compound. The intermetallic compound of the second joint 26 may be the same as the intermetallic compound of the first joint 23. Neither the intermetallic compound of the first joint 23 nor the intermetallic compound of the second joint 26 may be formed from or contain lead. This advantageously meets regulations which require lead-free semi-conductor devices.

The cover 18 is then provided in a conventional manner.

## Claims

1. : A clip (8) for a semi-conductor device (2), at least part of the clip (8) being formed from a metallic foam,
wherein a pore size of the foam is at least 10µm and up to 100µm and/or the part or parts of the clip (8) that is formed from a metallic foam have a porosity of at least 30% and/or up to 80%.

2. : The clip of any preceding claim, wherein the metallic foam is formed of copper.

3. : The clip of any preceding claim, wherein the metallic foam is an open cell foam.

4. : The clip of any preceding claim, wherein the entirety of the clip is formed from a metallic foam.

5. : A semi-conductor device (2) comprising:
a lead frame (4) that comprises a die attach portion (3) and a lead portion (5);
a semi-conductor die (6) mounted on the die attach portion (3);
a clip (8) according to any preceding claim, at least part of the clip (8) being secured to the semi-conductor die (6) and at least part of the clip (8) being secured to the lead portion (5).

6. : A method of manufacturing a semi-conductor device (2) comprising
providing a lead frame (4), the lead frame (4) comprising a die attach portion (3) and a lead portion (5);
attaching a semi-conductor die (6) to the die attach portion of the lead frame (4);
providing a first metallic layer (20) to the semi-conductor die (6) and providing a second metallic layer (22) to the lead portion (5);
providing the clip (8) of any of claims 1 to 4 such that a first portion (9) of the clip (8) contacts the first metallic layer (20) and a second portion (13) of the clip (8) contacts the second metallic layer (22); and
heating the clip (8), the first metallic layer (20), and the second metallic layer (22) such that the first metallic layer (20) and the second metallic layer (22) melt.

7. : The method of claim 6, wherein melting of the first metallic layer and of the second metallic layer causes the first metallic layer and the second metallic layer to migrate into the clip to form a first joint and a second joint respectively.

8. : The method of claim 7, wherein the melting temperature of the first joint and of the second joint is at least 400°C.

9. : The method of claim 7 or claim 8, wherein prior to being heated, the first metallic layer and the second metallic layer are formed from tin and the clip is formed from copper, and wherein the first joint and the second joint are formed from a copper-tin intermetallic compound.

10. : The method of any of claims 6 to 9, wherein neither the first metallic layer nor the second metallic layer are formed from lead.

## Patentansprüche

1. Clip (8) für eine Halbleitervorrichtung (2), wobei mindestens ein Teil des Clips (8) aus einem Metallschaum gebildet ist,
wobei eine Porengröße des Schaums mindestens 10 µm und bis zu 100 µm beträgt und/oder der Teil oder Teile des Clips (8), der aus einem Metallschaum gebildet ist, eine Porosität von mindestens 30 % und/oder bis zu 80 % aufweisen.

2. Clip nach einem der vorhergehenden Ansprüche, wobei der Metallschaum aus Kupfer gebildet ist.

3. Clip nach einem der vorhergehenden Ansprüche, wobei der Metallschaum ein offenzelliger Schaum ist.

4. Clip nach einem der vorhergehenden Ansprüche, wobei der gesamte Clip aus einem Metallschaum gebildet ist.

5. Halbleitervorrichtung (2), umfassend:
einen Leitungsrahmen (4), der einen Chipanschlussabschnitt (3) und einen Leitungsabschnitt (5) umfasst;
einen auf dem Chipanschlussabschnitt (3) montierten Halbleiterchip (6);
einen Clip (8) nach einem der vorhergehenden Ansprüche, wobei mindestens ein Teil des Clips (8) an dem Halbleiterchip (6) befestigt ist und mindestens ein Teil des Clips (8) an dem Leitungsabschnitt (5) befestigt ist.

6. Verfahren zum Fertigen einer Halbleitervorrichtung (2), umfassend:
Bereitstellen eines Leitungsrahmens (4), wobei der Leitungsrahmen (4) einen Chipanschlussabschnitt (3) und einen Leitungsabschnitt (5) umfasst;
Anschließen eines Halbleiterchips (6) an dem Chipanschlussabschnitt des Leitungsrahmens (4);
Bereitstellen einer ersten Metallschicht (20) für den Halbleiterchip (6) und Bereitstellen einer zweiten Metallschicht (22) für den Leitungsabschnitt (5);
Bereitstellen des Clips (8) nach einem der Ansprüche 1 bis 4, sodass ein erster Abschnitt (9) des Clips (8) die erste Metallschicht (20) berührt und ein zweiter Abschnitt (13) des Clips (8) die zweite Metallschicht (22) berührt; und
Erhitzen des Clips (8), der ersten Metallschicht (20) und der zweiten Metallschicht (22), sodass die erste Metallschicht (20) und die zweite Metallschicht (22) schmelzen.

7. Verfahren nach Anspruch 6, wobei das Schmelzen der ersten Metallschicht und der zweiten Metallschicht bewirkt, dass die erste Metallschicht und die zweite Metallschicht in den Clip eindringen, um eine erste Verbindung bzw. eine zweite Verbindung zu bilden.

8. Verfahren nach Anspruch 7, wobei die Schmelztemperatur der ersten Verbindung und der zweiten Verbindung mindestens 400 °C beträgt.

9. Verfahren nach Anspruch 7 oder Anspruch 8, wobei die erste Metallschicht und die zweite Metallschicht, bevor sie erhitzt werden, aus Zinn gebildet werden und der Clip aus Kupfer gebildet wird und wobei die erste Verbindung und die zweite Verbindung aus einer intermetallischen Kupfer-Zinn-Verbindung gebildet werden.

10. Verfahren nach einem der Ansprüche 6 bis 9, wobei weder die erste Metallschicht noch die zweite Metallschicht aus Blei gebildet werden.

## Revendications

1. Clip (8) pour dispositif à semi-conducteur (2), au moins une partie du clip (8) étant formée en une mousse métallique,
dans lequel la taille de pore de la mousse est d'au moins 10 µm et jusqu'à 100 µm et/ou la ou les parties du clip (8) formées en une mousse métallique ont une porosité d'au moins 30 % et/ou jusqu'à 80 %.

2. Clip selon toute revendication précédente, dans lequel la mousse métallique est formée de cuivre.

3. Clip selon toute revendication précédente, dans lequel la mousse métallique est une mousse à alvéoles ouvertes.

4. Clip selon toute revendication précédente, dans lequel l'intégralité du clip est formée en mousse métallique.

5. Dispositif semi-conducteur (2) comprenant :
une grille de connexion (4) qui comprend une partie de fixation de puce (3) et une partie de conducteur (5) ;
une puce semi-conductrice (6) montée sur la partie de fixation de puce (3) ;
un clip (8) selon toute revendication précédente, au moins une partie du clip (8) étant fixée à la puce semi-conductrice (6) et au moins une partie du clip (8) étant fixée à la partie de conducteur (5).

6. Procédé de fabrication d'un dispositif à semi-conducteur (2) comprenant :
la fourniture d'une grille de connexion (4), la grille de connexion (4) comprenant une partie de fixation de puce (3) et une partie de conducteur (5) ;
la fixation d'une puce semi-conductrice (6) à la partie de fixation de puce de la grille de connexion (4) ;
la fourniture d'une première couche métallique (20) à la puce semi-conductrice (6) et d'une seconde couche métallique (22) à la partie de conducteur (5) ;
la fourniture du clip (8) selon l'une quelconque des revendications 1 à 4 de telle sorte qu'une première partie (9) du clip (8) vienne en contact avec la première couche métallique (20) et qu'une seconde partie (13) du clip (8) vienne en contact avec la seconde couche métallique (22) ;
et
la chauffe du clip (8), de la première couche métallique (20) et de la seconde couche métallique (22) de telle sorte que la première couche métallique (20) et la seconde couche métallique (22) fondent.

7. Procédé selon la revendication 6, dans lequel la fusion de la première couche métallique et de la seconde couche métallique provoque la migration de la première couche métallique et de la seconde couche métallique dans le clip pour former respectivement un premier et un second joint.

8. Procédé selon la revendication 7, dans lequel la température de fusion du premier joint et du second joint est d'au moins 400 °C.

9. Procédé selon la revendication 7 ou 8, dans lequel, avant la chauffe, la première couche métallique et la seconde couche métallique sont formées d'étain et le clip est formé de cuivre, et dans lequel le premier joint et le second joint sont formés en un composé intermétallique cuivre-étain.

10. Procédé selon l'une quelconque des revendications 6 à 9, dans lequel ni la première couche métallique ni la seconde couche métallique ne sont formées de plomb.
